# EUROPEAN PATENT APPLICATION

(11) **EP 2 662 611 A1**
(43) Date of publication of application: **13.11.2013**
(21) Application number: 11854737.1
(22) Date of filing: 16.12.2011
(51) Int. Cl.: F21S 2/00, F21V 19/00, F21V 23/00, F21V 9/10, F21Y 101/02

(54) **LED MODULE AND ILLUMINATION DEVICE**

(30) Priority: 05.01.2011 CN 201110001035
(71) Applicant: Civilight Shenzhen Semiconductor Lighting Co., Ltd, Shenzhen, Guangdong 518108 (CN)
(72) Inventor: ZHOU, Yu, Guangdong 518108 (CN); ZHAO, Xigang, Guangdong 518108 (CN); XUE, Xinshen, Guangdong 518108 (CN)
(74) Representative: von Kreisler Selting Werner
(86) International application number: PCT/CN2011/084164
(87) International publication number: WO 2012/092808

(57) **Abstract**

The present invention relates to lighting field, provides an LED module, the LED module comprises a cuttable LED holder and a detachable drive circuit, the LED holder is provided with a plurality of LED lighting units with different power and different color temperature, the LED lighting unit comprises one or more LED chips and a packaging layer arranged at an outside of the LED chip, the drive circuit is connected to the LED chips and used for driving one or more of the LED chips to light. The LED module can be cut into modular units with required power, lighting color and color temperature, the LED module can be made by a kind of process to avoid the usage of various material and production devices, numerous and complicated processes aren't required, thus the problem of resource waste in the production of the LED module and low production efficiency is solved.

## Description

### BACKGROUND OF THE INVENTION

### 1. Technical Field

The present invention relates to lighting field, and more particularly, to an LED module and a lighting device.

### 2. Description of Related Art

A light-emitting diode (LED) as the fourth generation lighting source has the advantages of low energy consumption, compact size, green and environmental protection, improved resistance to severe environment, long service life and good security etc, which is hailed as a green lighting source in 21th century. At present, in the industry according to different market requirements, a large number of LEDs or LED modules with different power and color temperature are produced so as to satisfy all kinds of requirements in living and production. However, the production of the large number of LEDs or LED modules with different power and color temperature need to use different process, manufacture procedures and need to select appropriate material and corresponding production devices, while those process, material and corresponding production devices can't be used universally. Thus, resources are seriously wasted, and production efficiency is reduced.

### BRIEF SUMMARY OF THE INVENTION

A technical problem to be solved by the present invention is to overcome the shortcomings of low production efficiency of LED modules in the prior art and provide an LED module.

The present invention adopts the following technical solutions to solve the technical problem: an LED module, the LED module includes a cuttable LED holder and a detachable drive circuit, the LED holder is provided with a plurality of LED lighting units with different power and different color temperature, the LED lighting unit includes one or more LED chips and a packaging layer arranged at an outside of the LED chip, the drive circuit is connected to one or more of the LED chips and used for driving one or more of the LED chips to light.

Another object of embodiments of the presented invention is to provide a lighting device comprising a lighting component, wherein the lighting component is the abovementioned LED module.

In the embodiments of the presented invention, the plurality of LED lighting units with different power and color temperature are integrated on the cuttable LED holder, any one or more LED lighting units can be lighted by the detachable drive circuit to obtain emergent light with required power, color and color temperature. Meanwhile, because of the cuttable LED holder and the detachable drive circuit, the LED module can be cut in any manner to obtain modular units with different lighting color temperature and power, and the LED module can be used in any way, furthermore, the LED module can be made by a kind of process to avoid the usage of various material and production devices, numerous and complicated processes aren't required, thus the problem of resource waste in the production of the LED module and low production efficiency is solved.

### BRIEF DESCRIPTION OF THE SEVERAL VIEWS OF THE DRAWINGS

Fig. 1 is an exemplary structure view of the LED module according to the second embodiment of the present invention;
Fig. 2 i is an exemplary structure view of the LED module according to the third embodiment of the present invention; and
Fig. 3 is an exemplary structure view of the LED module according to the fourth embodiment of the present invention.

### DETAILED DESCRIPTION OF THE INVENTION

In order to make clearer the objects, technical solutions and advantages of the invention, the present invention will be explained below in detail with reference to the accompanying drawings and embodiments. It is to be understood that the following description of the embodiments is merely to explain the present invention and is no way intended to limit the invention.

In the embodiments of the presented invention, multiple LED lighting units with different power and color temperature are hold by the cuttable LED holder, any LED lighting unit can be lighted by the detachable drive circuit to obtain emergent light with different power and color temperature. Meanwhile, because of the cuttable LED holder and the detachable drive circuit, the LED module can be cut in any manner to obtain modular units with required lighting color temperature and power.

In the embodiments of the presented invention, a LED module is provided, the LED module includes a cuttable LED holder and a detachable drive circuit, the LED holder is provided with a plurality of LED lighting units with different power and different color temperature, the LED lighting unit includes one or more LED chips and a packaging layer arranged at an outside of the LED chip, the drive circuit is connected to the LED chips and used for driving one or more LED chips to light.

In the presented invention, multiple LED lighting units with different power and color temperature are integrated on the cuttable LED holder, any one or more LED lighting units can be lighted by the detachable drive circuit to obtain emergent light with required power, color and color temperature. Meanwhile, because of the cuttable LED holder and the detachable drive circuit, the LED module can be cut in any manner to obtain modular units with different lighting color temperature and power, and the LED module can be used in any way. Furthermore, the LED module can be made by a kind of process to avoid the usage of various material and production devices, numerous and complicated processes aren't required, thus the problem of resource waste in the production of the LED module and low production efficiency is solved.

### Embodiment 1:

According to the embodiment of the present invention, the LED module includes an LED holder and a drive circuit, a plurality of LED chips are hold by the LED holder, a packaging layer is provided at the outside of the LED chip, the plurality of LED chips can share an integral packaging layer, or each LED chip corresponds to one packaging layer, thus each LED chip and its corresponding packaging layer can form an LED lighting unit, and the LED chips can be driven to light by the drive circuit. In order to solve the problem of resource waste in the production of the LED module with different power and different color temperature and low production efficiency, according to the embodiment 1 of the present invention, the LED holder can be designed as a cuttable holder which can be cut in any manner, the drive circuit is designed as a detachable circuit which can be detached in any manner. Furthermore, the LED holder can be provided with a plurality of LED lighting units with different power and different color temperature, the plurality of LED lighting units are independent with each other, adjacent LED lighting units are electrically connected, and the drive circuit can be used to drive any LED chip or any number of LED chips to light, so that emergent light with multiple power, colors and color temperature can be obtained.

In this embodiment, the LED holder can be a holder having grooves or bosses therein, the grooves or bosses are used for holding the LED chips and are easy for dispensing glue, and each groove or boss can hold one or a plurality of LED chips. When the LED holder is provided with grooves, the LED chips are placed in the grooves, an integral euphotic layer, namely a packaging layer, can be disposed on the surface of the entire LED holder, therefore all the LED chips are covered by the packaging layer. It also can be provided with one packaging layer above each groove correspondingly. When the LED holder is provided with bosses, the LED chips are placed on the bosses, dispensing glue can be performed on each boss so as to form packaging layers, it is also possible to share a packaging layer with a large area for several bosses, in particular the packaging manner is determined by actual production processes. It is should be understood that the LED holder also can be flat, the LED chips are fixed on the flat holder directly, similarly, the packaging layer can be formed by several independent euphotic layers, wherein an LED chip corresponds to a euphotic layer or several euphotic layers, the packaging layer also can be formed by an integral euphotic layer with a large area, and all the LED chips can be covered by the integral euphotic layer.

One or more LED lighting units in the LED module provided in this embodiment can be lighted as required so as to obtain emergent light with required power, color and color temperature. The LED holder can be cut in any manner to obtain required modular units, since the drive circuit can be detached in any manner, the cut modular units still can work normally. One or more LED lighting units in the cut modular unit can be lighted by the drive circuit so as to obtain emergent light with required power, color and color temperature. Furthermore, multiple LED chips can be arranged in the groove or boss of the LED holder , therefore, a single lighting unit obtained by cutting the LED module includes one LED chip or multiple LED chips.

The LED module can be made by a kind of process to avoid the usage of various material and production devices, numerous and complicated processes aren't required, thus the problem of resource waste in the production of the LED module and low production efficiency is solved.

### Embodiment 2:

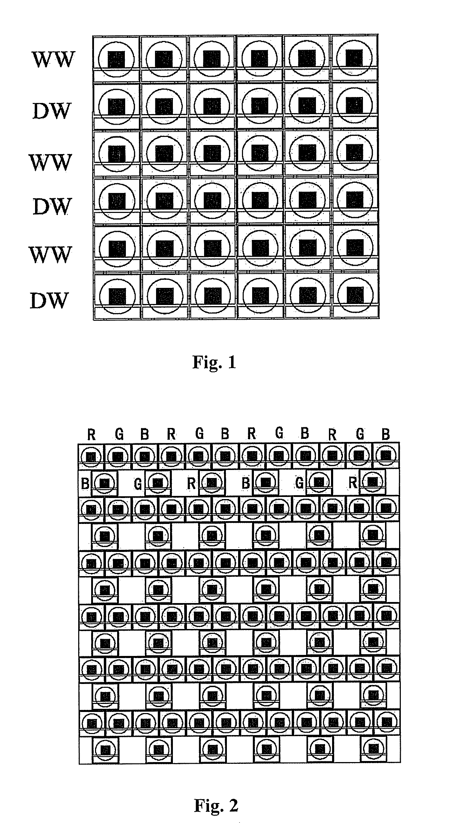

Fig.1 shows an exemplary structure of the LED module according to the second embodiment of the present invention, In order to be easily illustrated, only parts related to the embodiment are illustrated.

In the embodiment of the present invention, in order to obtain emergent light with multiple colors and color temperature, the surface of the LED chips can be coated with phosphors, in particular part of or all of LED chips can be coated with phosphors. Thus the phosphors can be activated to emit fluorescence by light of the LED chips, the light used to activate the phosphors and the fluorescence are mixed, the emergent light with multiple colors and color temperature can be obtained accordingly.

Referring to Fig. 1, as an example, all of the LED chips can be LED chips emitting blue light. Phosphors is activated to emit yellow fluorescence by the blue light, the blue light and yellow light are mixed to form white light. The surface of the LED chips emitting blue light can be coated with two types of phosphors so as to obtain two kinds of white LED lighting units with different color temperature, wherein part of the LED chips emits blue light, the phosphors are activated to obtain daylight white (DW) light with color temperature 5000∼10000K, another part of the LED chips emits blue light, the phosphors are activated to obtain warm white (WW) light with color temperature 2400∼3500K, the DW light lighting units and the WW light lighting units can be arranged alternately. The LED module can be used as an integral lighting component, and any number of lighting units of the LED module also can be lighted according to actual requirement. The LED module also can be cut to single DW light lighting sources or WW light lighting sources with small power, the LED module also can be cut by row, for example, 1*3 or 1*4, so as to obtain DW light modular units or WW light modular units with large power. The LED module also can be cut to obtain modular units including multiple rows and multiple columns, for example, 2*3 or 3*5, and emitting mixing light of DW light and WW light. After multiple DW light lighting units and WW light lighting units are lighted at the same time, the emitted light is mixed and natural (NW) light with color temperature 3500∼5000K is obtained.

### Embodiment 3:

Fig.2 shows an exemplary structure of the LED module according to the third embodiment of the present invention, In order to be easily illustrated, only parts related to the embodiment are illustrated.

In the embodiment of the present invention, an LED chip can be a combination of red LED chip, a green LED chip and a blue chip. For the LED module, as an integral lighting module, LED lighting units with one color on the LED module can be lighted to obtain monochromatic light, three types of LED lighting units on the LED module also can be lighted so as to obtain white light by mixing red light, green light and blue light. It should be understood that the LED module can be cut based on requirement, for a cut LED modular unit, LED lighting units with one color on the LED modular unit can be lighted to obtain monochromatic light, three types of LED lighting units on the LED modular unit can be lighted so as to obtain white light by mixing the light with three colors.

Referring to Fig. 2, as an implementation of the embodiment of the present invention, a red LED chip, a green LED chip and a blue LED chip can be arranged to form a triangle. All the vertices of the triangle correspond to the red LED chip, the green LED chip and the blue chip, therefore, when LED lighting units with three colors are lighted at the same time, white light is formed. The LED module also can be cut so as to obtain modular units with required colors and color temperature based on an actual requirement.

### Embodiment 4:

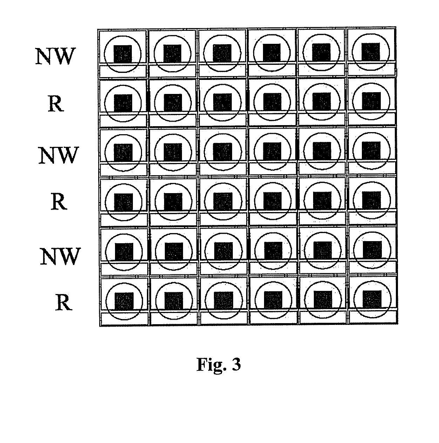

Fig. 3 shows an exemplary structure of the LED module according to the fourth embodiment of the present invention, In order to easily illustrate, only parts related to the embodiment are illustrated.

In the embodiment of the present invention, an LED chip can be a combination of a blue LED chip and a red LED. The surface of the blue LED chip can be coated with phosphors so as to form a white light lighting unit with lighting color temperature 3500∼5000K. The white light lighting unit can be lighted independently to obtain natural white light, the red light lighting unit also can be lighted independently to obtain red light. It should be understood that a modular unit with required lighting color and color temperature can be obtained by cutting the LED module based on an actual requirement.

Referring Fig. 3, as an implementation of the embodiment of the present invention, the white light lighting units and the red light lighting units can be arranged alternately. The white light lighting unit or red light lighting unit can be lighted independently to obtain light with a corresponding color, the white light lighting unit and red light lighting unit also can be lighted at the same time to obtain WW light. The LED module also can be cut into single natural white light lighting sources or single red light lighting sources with small power, the LED module also can be cut by one row and multiple columns so as to obtain natural white light modular units or red light modular units with large power, the LED module also can be cut by multiple rows and multiple columns into natural white light modular units or red light modular units with large power, in order to obtain WW light with color temperature 2400∼3500K. This has the advantages that usage of the red light lighting unit enriches spectrum of the LED module, improves color rendering properties of lighting production.

In the presented invention, multiple LED lighting units with different power and color temperature are integrated on the cuttable LED holder, any one or more LED lighting units can be lighted by the detachable drive circuit to obtain emergent light with required power, color and color temperature. Meanwhile, because of the cuttable LED holder and the detachable drive circuit, the LED module can be cut in any manner to obtain modular units with different lighting color temperature and power. The LED module can be made by a kind of process to avoid the usage of various material and production devices, numerous and complicated processes aren't required, thus the problem of resource waste in the production of the LED module and low production efficiency is solved. The DW light, WW light and natural white light can be obtained by coating all of or part of the LED chips with phosphors, or by combining the red LED chip, the green LED chip and the blue LED chip, the modular units with required power, color and color temperature can be obtained by cutting the LED module based on the actual requirement.

The present invention has been further detailed in the above descriptions with reference to the preferred embodiments; however, it shall not be construed that implementations of the present invention are only limited to these descriptions. Many simple deductions or replacements may further be made by those of ordinary skill in the art without departing from the conception of the present invention, and all of the deductions or replacements shall be considered to be covered within the protection scope of the present invention.

## Claims

1. An LED module, **characterized in that** the LED module comprises a cuttable LED holder and a detachable drive circuit, the LED holder is provided with a plurality of LED lighting units with different power and different color temperature, the LED lighting unit comprises one or more LED chips and a packaging layer arranged at an outside of the LED chips, the drive circuit is connected to the LED chips and used for driving one or more of the LED chips to light.

2. The LED module of Claim 1, **characterized in that** the LED chip is a red LED chip, a green LED chip, a blue LED chip or any combination of the red LED chip, the green LED chip, the blue LED chip.

3. The LED module of Claim 1, **characterized in that** all or part of the LED chips are coated with phosphors, different LED chips are coated by different phosphors so as to obtain emergent light with different color temperature.

4. The LED module of Claim 3, **characterized in that** emergent light emitted by the LED lighting units comprises monochromatic light, daylight white light with color temperature 5000K∼10000K, warm white with color temperature 2400∼3500K and natural white light with color temperature 3500K∼5000K.

5. The LED module of Claim 1, **characterized in that** the LED holder is flat.

6. The LED module of Claim 1, **characterized in that** the LED holder comprises grooves or bosses used for holding the LED chips, each groove or boss is used for holding one or more LED chips.

7. The LED module of Claim 6, **characterized in that** the packaging layer is a euphotic layer corresponding to a groove or boss one to one.

8. The LED module of any of Claims 1 to 6, **characterized in that** the packaging layer is an integral euphotic layer used for packaging all the LED chips.

9. The LED module of any of Claims 1 to 6, **characterized in that** the plurality of chips are connected in parallel, in series or by combination of paralleling and series connection.

10. A lighting device, comprising a lighting component, **characterized in that** the lighting component is the LED module of any of Claims 1 to 9.

## Amended claims

### Amended claims under Art. 19.1 PCT

**1.** An LED module, **characterized in that** the LED module comprises a cuttable LED holder and a detachable drive circuit so that the LED module can be cut in any manner to obtain modular units with different lighting color temperature and power, the LED holder is provided with a plurality of LED lighting units with different power and different color temperature, the LED lighting unit comprises one or more LED chips and a packaging layer arranged at an outside of the LED chips, the drive circuit is connected to the LED chips and used for driving one or more of the LED chips to light, emergent light emitted by the LED lighting units comprises monochromatic light, daylight white light with color temperature 5000K∼10000K, warm white with color temperature 2400∼3500K and natural white light with color temperature 3500K∼5000K.

**2.** The LED module of Claim 1, **characterized in that** the LED chip is a red LED chip, a green LED chip, a blue LED chip or any combination of the red LED chip, the green LED chip, the blue LED chip.

**3.** The LED module of Claim 1, **characterized in that** all or part of the LED chips are coated with phosphors, different LED chips are coated by different phosphors so as to obtain emergent light with different color temperature.

**4.** The LED module of Claim 1, **characterized in that** the LED holder is flat.

**5.** The LED module of Claim 1, **characterized in that** the LED holder comprises grooves or bosses used for holding the LED chips, each groove or boss is used for holding one or more LED chips.

**6.** The LED module of Claim 5, **characterized in that** the packaging layer is a euphotic layer corresponding to a groove or boss one to one.

**7.** The LED module of any of Claims 1 to 5, **characterized in that** the packaging layer is an integral euphotic layer used for packaging all the LED chips.

**8.** The LED module of any of Claims 1 to 5, **characterized in that** the plurality of chips are connected in parallel, in series or by combination of paralleling and series connection.

**9.** A lighting device, comprising a lighting component, **characterized in that** the lighting component is the LED module of any of Claims 1 to 8.
